(19) Europäisches Patentamt
European Patent Office
Office européen des brevets

(11) **EP 3 996 235 A1**

(12) **EUROPÄISCHE PATENTANMELDUNG**

(43) Veröffentlichungstag:
**11.05.2022   Patentblatt 2022/19**

(21) Anmeldenummer: **21020474.9**

(22) Anmeldetag: **22.09.2021**

(51) Internationale Patentklassifikation (IPC):
**H02J 7/00** (2006.01)   **B60L 58/12** (2019.01)
**B60L 58/19** (2019.01)   **H02J 7/02** (2016.01)

(52) Gemeinsame Patentklassifikation (CPC):
**H02J 7/0048; B60L 58/12; B60L 58/19;**
**H02J 7/0013; H02J 7/0024; H02J 7/02;**
H02J 2207/20; H02J 2207/40; H02J 2310/48

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(30) Priorität: **05.11.2020   DE 102020129131**

(71) Anmelder: **Dr. Ing. h.c. F. Porsche AG
70435 Stuttgart (DE)**

(72) Erfinder:
• **Simon, Daniel
71638 Ludiwgsburg (DE)**
• **Specht, Eduard
76646 Bruchsal (DE)**
• **Kacetl, Jan
67657 Kaiserslautern (DE)**
• **Kacetl, Tomas
67657 Kaiserlautern (DE)**
• **Jaensch, Malte
74321 Bietigheim-Bissingen (DE)**
• **Götz, Stefan
85659 Forstern (DE)**

(54) **VERFAHREN UND SYSTEM ZU EINER LADEZUSTANDSBEOBACHTUNG EINER WECHSELSTROMBATTERIE**

(57)   Die Erfindung betrifft ein Verfahren zu einer Ladezustandsbeobachtung einer Wechselstrombatterie, bei dem die Wechselstrombatterie einen Zentralkontroller mit einem Scheduler, Messsensoren und mindestens zwei Batteriemodule umfasst, wobei die mindestens zwei Batteriemodule jeweilig mindestens einen Energiespeicher und mindestens zwei Leistungshalbleiterschalter, welche das jeweilige Batteriemodul seriell oder parallel oder in Bypass zu einem anderen Batteriemodul verschalten, aufweisen, wobei dem die Wechselstrombatterie von dem Zentralkontroller gesteuert wird und durch den Scheduler ein jeweiliger Schaltzustand der mindestens zwei Batteriemodule vorgegeben wird, wobei die Ladezustandsbeobachtung durch ein Steuerprogramm innerhalb des Schedulers realisiert wird, wobei bei Betrieb der Wechselstrombatterie ein Zustand jedes einzelnen Energiespeichers überwacht wird, indem anhand einer fortgeführten Auswertung von durch Messsensoren erfassten Messwerten vorgegebener Batterieparameter ein jeweiliger Stromfluss an einem jeweiligen Energiespeicher ermittelt und daraus ein Messungsladezustand abgeschätzt wird, anhand einer fortgeführten Protokollierung der jeweiligen Schaltzustände, eines jeweiligen Phasenstromes, und von bei jeweiligen Schaltzuständen der Wechselstrombatterie vorliegenden Impedanzen ein jeweiliger Stromfluss errechnet und daraus ein Beobachtungsladezustand abgeschätzt wird, und die Ladezustandsbeobachtung aus einem Zusammenschluss des Messungsladezustandes und des Beobachtungsladezu- standes gebildet wird. Ferner wird ein System, auf dem das Verfahren ausgeführt wird, vorgestellt.

Fig. 1

**Beschreibung**

Die vorliegende Erfindung betrifft ein Verfahren zu einer Ladezustandsbeobachtung, die innerhalb einer Steuerung einer Wechselstrombatterie implementiert ist. Ferner wird ein System, auf dem das Verfahren ausgeführt wird, vorgestellt.

Zur Energieversorgung eines Traktionsmotors eines Elektrofahrzeuges werden Wechselrichter eingesetzt, welche eine Gleichspannung einer Traktionsbatterie in eine gewünschte Wechselspannung umsetzen. Eine Weiterentwicklung herkömmlicher fest verdrahteter Batterien stellen moderne Wechselrichter dar, bspw. gebildet durch modulare Multilevelkonverter, bei denen mehrere elektrisch verbundene Module, die jeweils mindestens einen Energiespeicher und mehrere Halbleiterschalter zum Verschalten der Energiespeicher zwischen den Modulen aufweisen, in mindestens einem Modulstrang angeordnet sind. Durch eine dynamische Verschaltung kann so aus einer Gleichspannung der Energiespeicher eine Wechselspannung bspw. zum Betreiben einer elektrischen Maschine erzeugt werden. Ein Beispiel stellt der von R. Marquardt in der Druckschrift US 2018/0109202 offenbarte modulare Multilevelkonverter, auch als MMC oder M2C abgekürzt, dar. Meist steuert ein zentrales Steuergerät die jeweilige Verschaltung der Module. Eine möglichst genaue Abschätzung eines Ladezustandes der jeweiligen Energiespeicher ist dabei von essentieller Bedeutung, um durch eine geeignete Steuerung eine ungleiche Lastverteilung zwischen den Energiespeichern zu vermeiden.

Die Druckschrift US 2013/0300425 A1 beschreibt ein Verwaltungssystem für ein elektrisches Speichergerät, welches einen Spannungssensor, einen Computerspeicher, und eine Steuerung umfasst. Der Spannungssensor misst eine Spannung an einer elektrischen Speichervorrichtung, wobei eine Korrelation zwischen einer Leerlaufspannung und einem Ladezustand einschließlich eines Bereichs mit geringfügiger Änderung und eines Bereichs mit starker Änderung erfasst wird und in dem Computerspeicher abgespeichert wird. Mit diesen Daten ist die Steuerung in der Lage, den Ladezustand des elektrischen Speichergerätes zu bestimmen.

In der US-amerikanischen Druckschrift US 2015/0158395 A1 wird der Ladezustand einer Traktionsbatterie aus Betriebsparametern wie Zellspannungen und Impedanzen bestimmt. Eine Steuerung implementiert hierzu einen Zustandsbeobachter, um diese Werte auf Grund einer Modellierung einer von solchen Betriebsparametern abhängigen Strommessvorspannung an jeder Energiezelle zu berechnen.

Die Druckschrift US 2019/0339330 A1 offenbart ein Verfahren zum Schätzen eines Ladezustands für eine Batteriezelle, wobei insbesondere verschiedene Betriebszustände der Batteriezelle berücksichtigt werden. Die Schätzung beruht auf Messungen eines mittleren Stromwertes zu jeder Batteriezelle.

Eine auf einer Integration von gemessenen Stromwerten basierende Abschätzung des Ladezustandes kann trotz des beträchtlichen Aufwands von über die Traktionsbatterie verteilten Messsensoren relativ ungenau sein. Zusätzlich werden solche verteilten Messungen durch ein Steuergerät durchgeführt, so dass eine zentrale Steuerung erst nach Messungsverarbeitung und Datenübertragung den Ladezustand durch einen Regelalgorithmus beeinflussen kann.

Vor diesem Hintergrund ist es eine Aufgabe der vorliegenden Erfindung, ein Verfahren zu einer Ladezustandsbeobachtung einer Wechselstrombatterie vorzustellen, wobei die Ladezustandsbeobachtung auf einer zentralen Steuerung der Wechselstrombatterie implementiert ist und eine verbesserte Abschätzung des Ladezustandes bereitstellt, welche nicht nur auf gemessenen Stromwerten beruht. Ferner soll ein System, auf dem das Verfahren ausgeführt wird, vorgestellt werden.

Zur Lösung der voranstehend genannten Aufgabe wird ein Verfahren zu einer Ladezustandsbeobachtung einer Wechselstrombatterie vorgeschlagen, bei dem die Wechselstrombatterie einen Zentralkontroller mit einem Scheduler, Messsensoren und mindestens zwei Batteriemodule umfasst. Die mindestens zwei Batteriemodule weisen jeweilig mindestens einen Energiespeicher und mindestens zwei Leistungshalbleiterschalter, welche das jeweilige Batteriemodul seriell oder parallel oder in Bypass bzw. unter Umgehung zu einem anderen Batteriemodul verschalten, auf. Die Wechselstrombatterie wird von dem Zentralkontroller gesteuert, wobei durch den Scheduler ein jeweiliger Schaltzustand der mindestens zwei Batteriemodule vorgegeben wird und die Ladezustandsbeobachtung durch ein Steuerprogramm innerhalb des Schedulers realisiert wird. Bei Betrieb der Wechselstrombatterie wird ein Zustand jedes einzelnen Energiespeichers überwacht, indem anhand einer fortgeführten Auswertung von durch Messsensoren erfassten Messwerten vorgegebener Batterieparameter ein jeweiliger Stromfluss an einem jeweiligen Energiespeicher ermittelt und daraus ein Messungsladezustand abgeschätzt wird. Weiter wird anhand einer fortgeführten Protokollierung der jeweiligen Schaltzustände, eines jeweiligen Phasenstromes, einer jeweiligen Phasenspannung, und von bei jeweiligen Schaltzuständen der Wechselstrombatterie vorliegenden Impedanzen ein jeweiliger Stromfluss errechnet und daraus ein Beobachtungsladezustand abgeschätzt. Aus einem Zusammenschluss des Messungsladezustandes und des Beobachtungsladezustandes wird die Ladezustandsbeobachtung gebildet.

Der Zusammenschluss des Messungsladezustandes und des Beobachtungsladezustandes wird bspw. mittels eines Kalman-Filters ausgeführt. Das erfindungsgemäße Verfahren verbessert damit vorteilhaft Präzession und Qualität der Ladezustandsbeobachtung.

Die Impedanzen ergeben sich aus Impedanzen der jeweiligen Leistungshalbleiterschalter, der jeweiligen Energiespeicher, der jeweilig geschalteten Batteriemodule und des daraus sich jeweilig ergebenden Stromverlaufs in stromführenden Leitungen.

Die fortgeführte Auswertung von durch Messsensoren erfassten Messwerten bedeutet, dass die Auswertung von Messwerten jeweilig erneut zu bzw. mit einem vorgebebenen Schaltungstakt, mit welchem auch die Leistungshalbleiterschalter der mindestens zwei Batteriemodule geschaltet werden, ausgeführt wird.

Für die Ansteuerung der Wechselstrombatterie, die zeitlich und vom jeweiligen Ladezustand abhängig koordiniert werden muss, ist eine programmtechnische Hardware-Umsetzung gemäß dem erfindungsgemäßen Verfahren vorteilhaft, da Anpassungen im Zustandsautomaten an ein programmtechnisch gesteuertes Fahrzeuggesamtsystem und/oder eine programmtechnisch gesteuerte Wechselstrombatterie, etwa einen modularen Multilevelkonverter mit serieller und paralleler Konnektivität, bspw. beschrieben in "Goetz, S.M.; Peterchev, A.V.; Weyh, T., "Modular Multilevel Converter With Series and Parallel Module Connectivity: Topology and Control," Power Electronics, IEEE Transactions on , vol.30, no.1, pp.203,215, 2015. doi: 10.1109/TPEL.2014.2310225, einfach, unkompliziert und rein programmtechnisch vorgenommen werden können.

Die Wechselstrombatterie kann durch eine jeweilige seriell-parallele Verschaltung ihrer Batteriemodule untereinander eine Klemmenspannung zwischen einem Negativbetrag und einem Positivbetrag einer Maximalspannung (Faktor N einer Batteriemodulspannung, wobei N eine Anzahl der Batteriemodule ist) aktiv einstellen. Auch jenseits der sich aus einer seriellen oder parallelen Verschaltung oder möglichen Kombinationen daraus ergebenden Klemmenspannung, lässt sich durch hochfrequentes Umschalten oder Zu- und Abschalten einzelner Batteriemodule ein sich im zeitlichen Mittel ergebender beliebiger Wert zwischen Negativbetrag und Positivbetrag der Maximalspannung für die Klemmenspannung einstellen. Die Einstellung führt das Steuerprogramm auf dem Zentralkontroller aus, welches die seriell-parallele Verschaltung der Batteriemodule unter Berücksichtigung der jeweiligen Zustände der Energiespeicher steuert.

In einer Ausführungsform des erfindungsgemäßen Verfahrens werden die vorgegebenen Batterieparameter aus folgender Liste gewählt: Phasenstrom, Spannung an jedem Energiespeicher, Batteriemodulimpedanz, Kontrollsignale, parallele/serielle/bypass-Schaltkonfiguration der jeweiligen Batteriemodule. Mehrere Batteriemodule der Wechselstrombatterie sind bspw. aneinandergereiht in einem jeweiligen Strang angeordnet, wobei der jeweilige Strang den jeweiligen Phasenstrom eines Elektromotors eines Fahrzeuges bildet. Die Batteriemodulimpedanz setzt sich aus einer Impedanzmatrix aus Impedanzwerten von jeweiligen Schaltern der Batteriemodule, Energiespeichern, Leitungen etc. zusammen. Ein jeweiliger Messsensor, wie bspw. ein Phasenstromsensor, kann den jeweiligen Phasenstrom der Wechselstrombatterie in deren Verbindung zum Elektromotor messen. Zur Messung der Spannung an jedem Energiespeicher wird ein jeweiliger Messsensor im jeweiligen Batteriemodul angeordnet.

In einer weiteren Ausführungsform des erfindungsgemäßen Verfahrens wird der Scheduler auf einer Prozessoreinheit und einem FPGA ausgeführt. Die Schaltzustände und der Beobachtungsladezustand werden auf dem FPGA ermittelt und der Messungsladezustand wird auf der Prozessoreinheit ermittelt. Das FPGA steht als Abkürzung für ein "Field Programmable Gate Array", zu Deutsch "betriebsbezogene programmierbare Gatter-Anordnung". Auf einem FPGA ist bspw. zu einem Start des die erfindungsgemäße Ansteuerung der Wechselstrombatterie aufweisenden Elektrofahrzeuges eine jeweilige Prozessor-Programmierung konfigurierbar. Das FPGA kann vorteilhaft mit einem Mikrocontroller verbunden sein oder das FPGA kann zusätzlich einen Mikrocontroller umfassen. In einer weiter fortgesetzten Ausführungsform ist es auch denkbar, das Steuerprogramm auf einem Mikrocontroller oder einer anwendungsspezifischen integrierten Schaltung, vom Fachmann mit "Application-specific Integrated Circuit" bzw. ASIC bezeichnet, auszuführen. Eine Kombination aus Mikrocontroller und FPGA/ASIC stellt eine weitere vorteilhafte Ausführungsform dar. Durch eine unmittelbare räumliche Nähe der Berechnungen für den Beobachtungsladezustand auf dem FPGA und den Messungsladezustand auf der dazu benachbarten Prozessoreinheit wird vorteilhaft eine schnellstmögliche Zusammenführung zu der Ladezustandsbeobachtung ermöglicht. Der Scheduler kann somit direkt und ohne übertragungsbedingte Zeitverluste auf diese Ladezustandsbeobachtung zugreifen.

In einer noch weiteren Ausführungsform des erfindungsgemäßen Verfahrens wird der jeweilige Stromfluss zur Abschätzung des Beobachtungsladezustandes gemäß einer Zuordnungstabelle, welche zu allen Schaltzuständen und möglichen Kombinationen der Batteriemodule einen jeweiligen Stromwert aufweist, berechnet. In einem denkbaren modellbasierten Ansatz zu einer Überwachung von Betriebszuständen der Batteriemodule werden Messwerte der Messsensoren dazu verwendet, die Zuordnungstabelle fortgeführt zu aktualisieren.

In einer fortgesetzt noch weiteren Ausführungsform des erfindungsgemäßen Verfahrens wird der jeweilige Stromfluss zur Abschätzung des Beobachtungsladezustandes anhand einer vereinfachten Funktion, welche eine Verteilungsmatrix über die jeweiligen Spannungen der Energiespeicher zusammen mit den Batteriemodulimpedanzen enthält, berechnet. Vereinfachung bedeutet hier, dass mindestens einer der den jeweiligen Stromfluss beeinflussenden Parameter, als konstant gesetzt wird. So sei bspw. ein Stromfluss $I_k$ durch ein Batteriemodul $k$ gegeben durch

$$I_k = f(s, i_{phase}, Z, V_k), \qquad (1)$$

wobei *s* eine jeweilige Konfiguration von Schaltzuständen bezeichnet, $i_{phase}$ der Phasenstrom ist, Z eine Matrix mit Batteriemodulimpedanzen darstellt und ein Vektor *V* mit *k*-tem Element $V_k$ eine Spannung des Energiespeichers des Batteriemoduls k beinhaltet. Die Matrix mit Batteriemodulimpedanzen Z und der Vektor *V* werden zu einer Verteilungsmatrix D zusammengefasst:

$$I_k = f(s, i_{phase}, D(Z, V_k)). \qquad (2)$$

Wird nun gemäß der fortgesetzt noch weiteren Ausführungsform bspw. die Verteilungsmatrix D durch konstante Einträge vereinfacht, so erhält man

$$I_k = f(s, i_{phase}, D). \qquad (3)$$

So kann bspw. ein Impedanzwert eines Leistungshalbleiterschalters verglichen mit der Batteriemodulimpedanz gleich Null gesetzt werden.
Ferner wird ein System zu einer Ladezustandsbeobachtung einer Wechselstrombatterie bereitgestellt, bei dem die Wechselstrombatterie einen Zentralkontroller mit einem Scheduler, Messsensoren und mindestens zwei Batteriemodule umfasst. Die mindestens zwei Batteriemodule weisen jeweilig mindestens einen Energiespeicher und mindestens zwei Leistungshalbleiterschalter, welche das jeweilige Batteriemodul seriell oder parallel oder in Bypass zu einem anderen Batteriemodul verschalten, auf. Der Zentralkontroller ist dazu konfiguriert, die Wechselstrombatterie zu steuern und der Scheduler ist dazu konfiguriert, einen jeweiligen Schaltzustand der mindestens zwei Batteriemodule vorzugeben. Ein Ladezustandsbeobachter ist innerhalb des Schedulers durch ein Steuerprogramm realisiert und dazu konfiguriert, bei Betrieb der Wechselstrombatterie anhand einer fortgeführten Auswertung von durch Messsensoren erfassten Messwerten vorgegebener Batterieparameter einen jeweiligen Stromfluss an einem jeweiligen Energiespeicher zu ermitteln und daraus einen Messungsladezustand abzuschätzen, weiter anhand einer fortgeführten Protokollierung der jeweiligen Schaltzustände, eines jeweiligen Phasenstromes, einer jeweiligen Phasenspannung, und von bei jeweiligen Schaltzuständen der Wechselstrombatterie vorliegenden Impedanzen einen jeweiliger Stromfluss zu errechnen und daraus einen Beobachtungsladezustand abzuschätzen, und die Ladezustandsbeobachtung aus einem Zusammenschluss des Messungsladezustandes und des Beobachtungsladezustandes zu bilden.
Durch den Ladezustandsbeobachter wird bei Betrieb der Wechselstrombatterie ein Ladezustand jedes einzelnen Energiespeichers überwacht, zudem anhand einer fortgeführten Auswertung von Messwerten vorgegebener Batterieparameter ein jeweiliger Stromfluss an einem jeweiligen Energiespeicher abgeschätzt und durch Integration oder Kumulation der jeweiligen Stromflüsse auf einen Ladezustand des jeweiligen Energiespeichers geschlossen. Neben Messwerten wertet der Ladezustandsbeobachter auch Kontrollsignale für einen jeweiligen Schaltzyklus aus. So weiß der Ladezustandsbeobachter von dem Zentralkontroller, wie die Batteriemodule untereinander verschaltet sind (parallel oder seriell) und berechnet daraus eine Stromverteilung.
Steuerungstheoretisch ist der erfindungsgemäße Ladezustandsbeobachter ein System, das eine Schätzung eines internen Ladezustandes eines gegebenen realen Systems aus Messungen eines Eingangs und eines Ausgangs des realen Systems bereitstellt. Er bietet damit eine Grundlage für viele Anwendungen, um eine Steuerung der modularen Wechselstrombatterie, wie bspw. durch eine dynamische Ansteuerung der Leistungshalbleiterschalter in einem jeweiligen Batteriemodul gemäß der Ladezustandsbeobachtung des jeweiligen Energiespeichers, eine ausgeglichene Lastverteilung zu realisieren.
In einer Ausgestaltung des erfindungsgemäßen Systems sind die vorgegebenen Batterieparameter aus folgender Liste gewählt: Phasenstrom, Spannung an jedem Energiespeicher, Batteriemodulimpedanz, Kontrollsignale, parallele/serielle/bypass-Schaltzustände der jeweiligen Batteriemodule.
In einer weiteren Ausgestaltung des erfindungsgemäßen Systems ist der Scheduler dazu konfiguriert, auf einer Prozessoreinheit und einem FPGA ausgeführt zu werden. Die Schaltzustände und der Beobachtungsladezustand werden auf dem FPGA ermittelt und der Messungsladezustand wird auf der Prozessoreinheit ermittelt.
In einer noch weiteren Ausgestaltung des erfindungsgemäßen Systems ist der Ladezustandsbeobachter dazu konfiguriert, die Berechnung des jeweiligen Stromflusses zur Abschätzung des Beobachtungsladezustandes gemäß einer Zuordnungstabelle, welche zu allen Schaltzuständen und möglichen Kombinationen der Batteriemodule einen jeweiligen Stromwert aufweist, durchzuführen.
In einer fortgesetzt noch weiteren Ausgestaltung des erfindungsgemäßen Systems ist der Ladezustandsbeobachter dazu konfiguriert, die Berechnung des jeweiligen Stromflusses zur Abschätzung des Beobachtungsladezustandes anhand einer vereinfachten Funktion, welche eine Verteilungsmatrix über die jeweiligen Spannungen der Energiespeicher zusammen mit den Batteriemodulimpedanzen enthält, durchzuführen.
Weitere Vorteile und Ausgestaltungen der Erfindung ergeben sich aus der Beschreibung und der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Figuren werden zusammenhängend und übergreifend beschrieben, gleichen Komponenten sind dieselben Bezugszeichen zugeordnet.

Figur 1 zeigt schematisch ein Schaltschema zu einer Ladezustandsbeobachtung in einer Ausführungsform des erfindungsgemäßen Verfahrens.

Figur 2 zeigt schematisch ein Schaltschema mit einer Aktualisierung einer Verteilungsmatrix in einer weiteren Ausführungsform des erfindungsgemäßen Verfahrens.

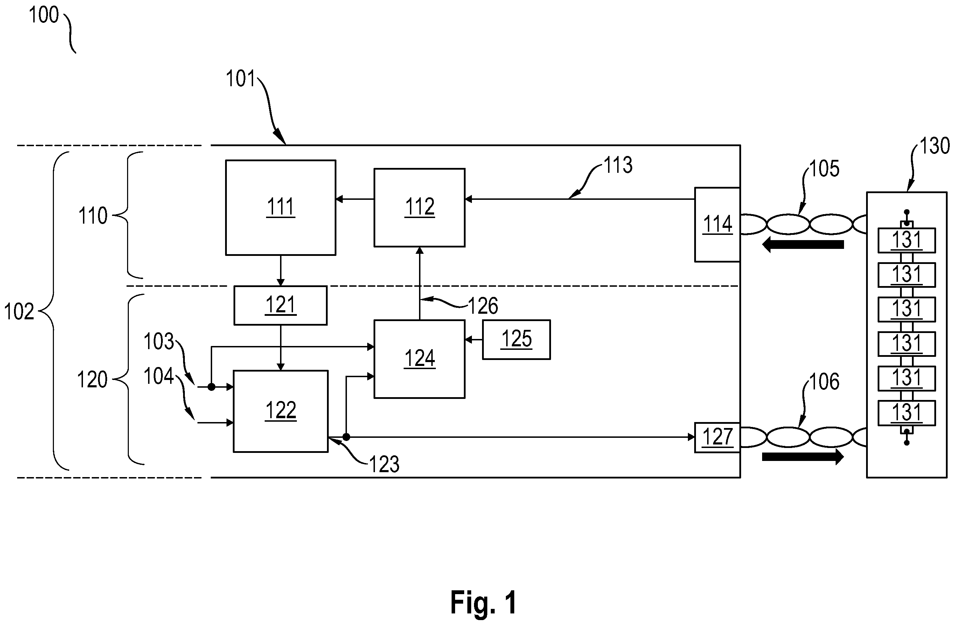

In Figur 1 wird schematisch ein Schaltschema 100 zu einer Ladezustandsbeobachtung in einer Ausführungsform des erfindungsgemäßen Verfahrens gezeigt, bei dem ein Scheduler 102 auf einem Zentralkontroller 101 zu einem Teil auf einem Prozessor 110 und zum anderen Teil auf einem FPGA 120 implementiert ist. Dem Scheduler 102 wird vom Zentralkontroller 101 ein gewünschter Phasenstrom $I_{phase}$ 103 bei einer gewünschten Phasenspannung $V_{phase}$ 104 zur Auswahl einer Schaltzustandskonfiguration 122 vorgegeben. Weiter gehen in die Auswahl der Schaltzustandskonfiguration 122 gespeicherte Werte einer Kostenfunktion 121 ein, welche jeweilige Schaltzustände gemäß den bspw. durch einen Wechsel zu ihnen verursachten Schaltverlusten bewerten. Ein ausgewählter Schaltzustand 123 dient einerseits zur fortgeführten Protokollierung der gewählten Schaltkonfiguration 123 und damit als Grundlage zu einer Ladezustandsbeobachtung 124, in die auch der gewünschte Phasenstrom $I_{phase}$ 103 eingeht, sowie eine gespeicherte Verteilungsmatrix 125 mit Spannungen und Impedanzen/Widerständen zu der jeweilig geschalteten Schaltkonfiguration 123 der Wechselstrombatterie 130. Andererseits wird der ausgewählte Schaltzustand 123 an eine Sendeeinheit 127 gegeben, welche diesen über einen Steuerbus 106 an eine modulare Wechselstrombatterie 130 übermittelt. In den Batteriemodulen 131 der Wechselstrombatterie 130 wird die gewählte Schaltkonfiguration 123 umgesetzt, was zu einem gemessenen Phasenstrom führt. Auch jeweilige Spannungen an Energiespeichern der jeweiligen Batteriemodule 131 werden gemessen. Solche und weitere Messwerte, wie bspw. Temperatur, werden in einem Datenbus 105 an eine Empfangseinheit 114 des Zentralkontrollers 101 übermittelt, woraufhin ein Messungsladezustand 113 zur Fusionierung 112 mit dem Beobachtungsladezustand 126 zusammengeführt wird. Die auf Grund der Fusionierung 112 erhaltene Abschätzung des Ladezustandes wird wiederum einer Berechnung der Kostenfunktion 111 zugeführt, bei der bspw. Wechsel zu allen möglichen Schaltzuständen neu bewertet werden und als Werte der Kostenfunktion 111 abgespeichert werden.

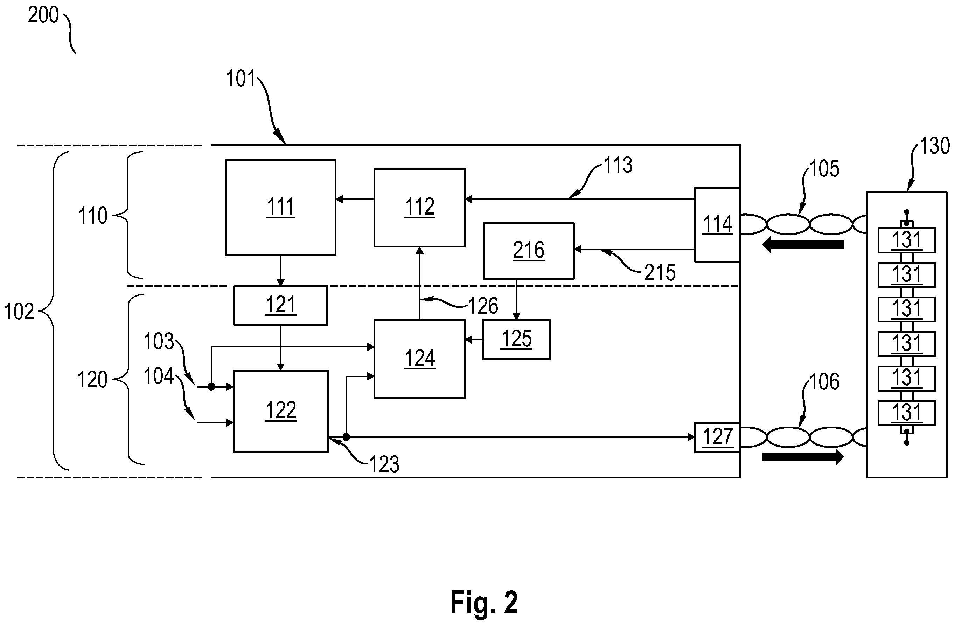

In Figur 2 wird schematisch ein Schaltschema 200 mit einer Aktualisierung einer Verteilungsmatrix in einer weiteren Ausführungsform des erfindungsgemäßen Verfahrens gezeigt. Die aus der Empfangseinheit 114 erhaltenen Spannungswerte 215 von Energiespeichern dienen einer fortgeführten Neuberechnung 216 einer Verteilungsmatrix mit Spannungen und Impedanzen/Widerständen zu der jeweilig von der Wechselstrombatterie 130 umgesetzten Schaltkonfiguration 123, welche dann als Verteilungsmatrix 125 abgespeichert wird.

**Patentansprüche**

1. Verfahren zu einer Ladezustandsbeobachtung (112) einer Wechselstrombatterie (130), bei dem die Wechselstrombatterie (130) einen Zentralkontroller (101) mit einem Scheduler (102), Messsensoren und mindestens zwei Batteriemodule (131) umfasst, wobei die mindestens zwei Batteriemodule (131) jeweilig mindestens einen Energiespeicher und mindestens zwei Leistungshalbleiterschalter, welche das jeweilige Batteriemodul (131) seriell oder parallel oder in Bypass zu einem anderen Batteriemodul (131) verschalten, aufweisen, wobei die Wechselstrom batterie (130) von dem Zentralkontroller (101) gesteuert wird und durch den Scheduler (102) ein jeweiliger Schaltzustand der mindestens zwei Batteriemodule (131) vorgegeben wird, wobei die Ladezustandsbeobachtung (112, 124) durch ein Steuerprogramm innerhalb des Schedulers (102) realisiert wird, wobei bei Betrieb der Wechselstrom batterie (130)

   • anhand einer fortgeführten Auswertung von durch Messsensoren erfassten Messwerten vorgegebener Batterieparameter ein jeweiliger Stromfluss an einem jeweiligen Energiespeicher ermittelt und daraus ein Messungsladezustand (113) abgeschätzt wird,
   • anhand einer fortgeführten Protokollierung der jeweiligen Schaltzustände (123), eines jeweiligen Phasenstromes (103), und von bei jeweiligen Schaltzuständen (123) der Wechselstrombatterie (130) vorliegenden Impedanzen ein jeweiliger Stromfluss errechnet und daraus ein Beobachtungsladezustand (126) abgeschätzt wird, und

• die Ladezustandsbeobachtung (112) aus einem Zusammenschluss des Messungsladezustandes (113) und des Beobachtungsladezustandes (126) gebildet wird.

2. Verfahren nach Anspruch 1, bei dem die vorgegebenen Batterieparameter aus folgender Liste gewählt werden: Phasenstrom, Spannung an jedem Energiespeicher, Batteriemodulimpedanz, Kontrollsignale, parallele/serielle/bypass-Schaltzustände (123) der jeweiligen Batteriemodule (131).

3. Verfahren nach einem der voranstehenden Ansprüche, bei dem der Scheduler (102) auf einer Prozessoreinheit (110) und einem FPGA (120) ausgeführt wird, wobei die Schaltzustände (123) und der Beobachtungsladezustand (126) auf dem FPGA (120) ermittelt werden und der Messungsladezustand (113) auf der Prozessoreinheit (110) ermittelt wird.

4. Verfahren nach einem der voranstehenden Ansprüche, bei dem der jeweilige Stromfluss zur Abschätzung des Beobachtungsladezustandes (126) gemäß einer Zuordnungstabelle, welche zu allen Schaltzuständen und möglichen Kombinationen der Batteriemodule (131) einen jeweiligen Stromwert aufweist, berechnet wird.

5. Verfahren nach einem der Ansprüche 1 bis 3, bei dem der jeweilige Stromfluss zur Abschätzung (124) des Beobachtungsladezustandes (126) anhand einer vereinfachten Funktion, welche eine Verteilungsmatrix (125) über die jeweiligen Spannungen der Energiespeicher zusammen mit den Batteriemodulimpedanzen enthält, berechnet wird.

6. System zu einer Ladezustandsbeobachtung (112) einer Wechselstrombatterie (130), bei dem die Wechselstrom batterie (130) einen Zentralkontroller (101) mit einem Scheduler (102), Messsensoren und mindestens zwei Batteriemodule (131) umfasst, wobei die mindestens zwei Batteriemodule (131) jeweilig mindestens einen Energiespeicher und mindestens zwei Leistungshalbleiterschalter, welche das jeweilige Batteriemodul (131) seriell oder parallel oder in Bypass zu einem anderen Batteriemodul (131) verschalten, aufweisen, wobei der Zentralkontroller (101) dazu konfiguriert ist, die Wechselstrom batterie (130) zu steuern und der Scheduler (102) dazu konfiguriert ist, einen jeweiligen Schaltzustand (123) der mindestens zwei Batteriemodule (131) vorzugeben, wobei ein Ladezustandsbeobachter (112, 124) innerhalb des Schedulers (102) durch ein Steuerprogramm realisiert ist und dazu konfiguriert ist, bei Betrieb der Wechselstrom batterie (130)

• anhand einer fortgeführten Auswertung von durch Messsensoren erfassten Messwerten vorgegebener Batterieparameter einen jeweiligen Stromfluss an einem jeweiligen Energiespeicher zu ermitteln und daraus einen Messungsladezustand (113) abzuschätzen,
• anhand einer fortgeführten Protokollierung der jeweiligen Schaltzustände (123), eines jeweiligen Phasenstromes (103), und von bei jeweiligen Schaltzuständen (123) der Wechselstrombatterie (130) vorliegenden Impedanzen einen jeweiligen Stromfluss zu errechnen und daraus einen Beobachtungsladezustand (126) abzuschätzen, und
• die Ladezustandsbeobachtung (112) aus einem Zusammenschluss des Messungsladezustandes (113) und des Beobachtungsladezustandes (126) zu bilden.

7. System nach Anspruch 6, bei dem die vorgegebenen Batterieparameter aus folgender Liste gewählt sind: Phasenstrom, Spannung an jedem Energiespeicher, Batteriemodulimpedanz, Kontrollsignale, parallele/serielle/bypass-Schaltzustände (123) der jeweiligen Batteriemodule (131).

8. System nach Anspruch 6 oder 7, bei dem der Scheduler (102) dazu konfiguriert ist, auf einer Prozessoreinheit (110) und einem FPGA (120) ausgeführt zu werden, wobei die Schaltzustände (123) und der Beobachtungsladezustand (126) auf dem FPGA (120) ermittelt werden und der Messungsladezustand (113) auf der Prozessoreinheit (110) ermittelt wird.

9. System nach einem Ansprüche 6 bis 8, bei dem der Ladezustandsbeobachter (112, 124) dazu konfiguriert ist, die Berechnung des jeweiligen Stromflusses zur Abschätzung des Beobachtungsladezustandes (126) gemäß einer Zuordnungstabelle, welche zu allen Schaltzuständen und möglichen Kombinationen der Batteriemodule einen jeweiligen Stromwert aufweist, durchzuführen.

10. System nach einem Ansprüche 6 bis 8, bei dem der Ladezustandsbeobachter (112, 124) dazu konfiguriert ist, die Berechnung des jeweiligen Stromflusses zur Abschätzung (124) des Beobachtungsladezustandes (126) anhand einer vereinfachten Funktion, welche eine Verteilungsmatrix (125) über die jeweiligen Spannungen der Energiespeicher zusammen mit den Batteriemodulimpedanzen enthält, durchzuführen.

**Fig. 1**

EP 3 996 235 A1

**Fig. 2**

Europäisches
Patentamt

European
Patent Office

Office européen
des brevets

**EUROPÄISCHER RECHERCHENBERICHT**

Nummer der Anmeldung

**EP 21 02 0474**

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | DE 10 2017 124126 A1 (PORSCHE AG [DE]) 18. April 2019 (2019-04-18) * Absätze [0017], [0082]; Abbildungen 1, 2, 3a, 5 * ----- | 1-10 | INV. H02J7/00 B60L58/12 B60L58/19 H02J7/02 |
| Y | US 2013/297243 A1 (BABA ATSUSHI [JP] ET AL) 7. November 2013 (2013-11-07) * Absätze [0018] – [0020], [0048], [0075]; Abbildung 1 * ----- | 1-10 | |

**RECHERCHIERTE SACHGEBIETE (IPC)**

H02J
B60L

Der vorliegende Recherchenbericht wurde für alle Patentansprüche erstellt

| Recherchenort | Abschlußdatum der Recherche | Prüfer |
|---|---|---|
| **München** | **10. März 2022** | **Telega, Pawel** |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus anderen Gründen angeführtes Dokument

................................................................

& : Mitglied der gleichen Patentfamilie, übereinstimmendes
  Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 21 02 0474

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-03-2022

| Im Recherchenbericht angeführtes Patentdokument | Datum der Veröffentlichung | Mitglied(er) der Patentfamilie | Datum der Veröffentlichung |
|---|---|---|---|
| DE 102017124126 A1 | 18-04-2019 | CN 109672353 A | 23-04-2019 |
| | | DE 102017124126 A1 | 18-04-2019 |
| | | US 2019115849 A1 | 18-04-2019 |
| | | | |
| US 2013297243 A1 | 07-11-2013 | CN 103328997 A | 25-09-2013 |
| | | EP 2667211 A1 | 27-11-2013 |
| | | JP 5318128 B2 | 16-10-2013 |
| | | JP 2012149947 A | 09-08-2012 |
| | | US 2013297243 A1 | 07-11-2013 |
| | | WO 2012098770 A1 | 26-07-2012 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20180109202 A
- US 20130300425 A1
- US 20150158395 A1
- US 20190339330 A1

**In der Beschreibung aufgeführte Nicht-Patentliteratur**

- **GOETZ, S.M. ; PETERCHEV, A.V. ; WEYH, T.** Modular Multilevel Converter With Series and Parallel Module Connectivity: Topology and Control. *Power Electronics, IEEE Transactions on,* 2015, vol. 30 (1), 203, , 215